# EUROPEAN PATENT SPECIFICATION

(11) **EP 0 986 105 B1**
(45) Date of publication and mention of the grant of the patent: **30.11.2005**
(21) Application number: 98830521.5
(22) Date of filing: 07.09.1998
(51) Int. Cl.: H01L 27/02, G05F 3/18

(54) **Electronic circuit for trimming integrated circuits**
Elektronischer Schaltkreis zum Trimmen integrierter Schaltungen
Circuit électronique pour l' ajustage des circuits intégrés

(43) Date of publication of application: 15.03.2000
(73) Proprietor: STMicroelectronics S.r.l., 20041 Agrate Brianza (Milano) (IT)
(72) Inventor: Marino, Filippo, 90142 Palermo (IT); Capici, Salvatore, 94012 Barrafranca (Enna) (IT)
(74) Representative: Botti, Mario

(56) References cited:
- EP-A- 0 599 072
- GB-A- 2 083 962
- GB-A- 2 270 795
- US-A- 4 412 241
- US-A- 5 450 030
- PATENT ABSTRACTS OF JAPAN vol. 11, no. 104 (E-494), 2 April 1987 & JP 61 253917 A (NIPPON DENSO CO LTD), 11 November 1986

## Description

### Field of the Invention

This invention relates to an electronic trimming circuit for integrated circuits.

More particularly, the invention relates to a circuit for carrying out a trimming operation on circuit portions of integrated circuits, including at least an input terminal and an output terminal connected to at least one of said circuit portions.

### Prior Art

As is well known in this specific technical field, whenever high-precision performance is demanded of an integrated circuit, the integrated circuit must be provided with additional circuit portions for modifying certain circuit parameters during the integrated circuit testing step. This modification operation is referred to as "trimming" in technical language.

The parameter modification is usually performed during the wafer testing step, i.e. during the EWS (Electrical Wafer Sort) test. In certain cases, however, it is also possible for this operation to be carried out during the device final testing.

One example of a circuit that requires this kind of a modification is a band-gap regulator for producing a constant voltage reference as much as possible independent of the ambient temperature at which the circuit is being operated. Regulators of this type are to be found in several systems based on integrated circuits, e.g. incorporated to cellular telephones, and more specifically to data communication devices employing portable phone sets.

At least two low-drop linear regulators are provided in such apparatus which must be made to strict specifications, especially in connection with their operating accuracy when such parameters as temperature, supply voltage, etc. vary.

It is for this reason that a trimming operation must be carried out on the regulator circuit after packaging the integrated circuit that is incorporating it.

Some different ways of providing trimming circuits are state of art. A particularly versatile, though highly complex, solution is disclosed in US Patent No. 4,875,020 to this Applicant.

There exist, however, simpler ways of providing the circuit portions dedicated to trimming.

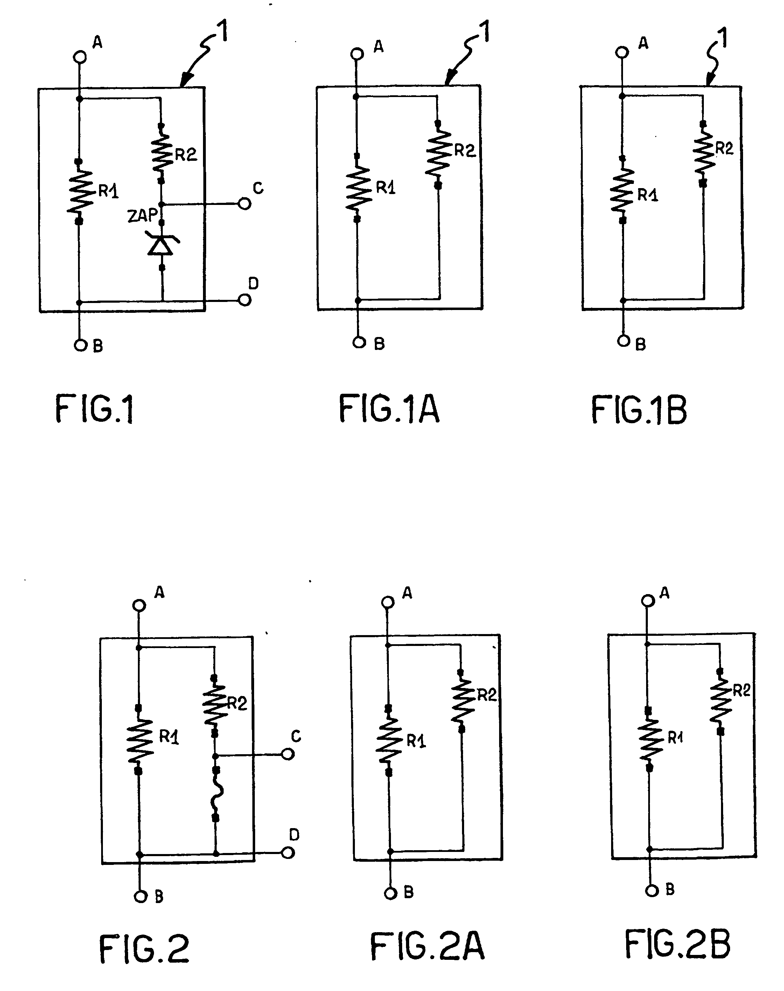

For example, Figure 1A shows schematically a conventional trimming circuit 1.

The circuit 1 is quite simple, and can be viewed as a dipole comprising a first resistor R1 connected between a terminal A and a terminal B. Connected in parallel with the resistor R1 is a series of a second resistor R2 and a ZAP Zener diode, which diode is used as a storage element.

The ZAP diode operates as an open circuit until the voltage across its terminals C and D exceeds 7V (for a component fabricated by a third-generation BCD process).

When the voltage across the diode exceeds 7V while a larger current than 250mA is being circulated, the diode characteristic becomes permanently changed. For example, the diode characteristic becomes by a few Ohms resistive.

Thus, if during the testing step the diode terminals C and D are made available, the resistance as seen from the terminals A and B can be varied, as shown in Figures 1A and 1B.

Figure 1A illustrates a situation of uncompleted trimming, and Figure 1B a situation of completed trimming.

A second prior solution is shown schematically in Figures 2, 2A and 2B.

Figure 2 shows the same structure as in Figure 1, with the single difference that a fuse FUSE is provided in place of the Zener diode ZAP. The operation of the trimming circuit shown in Figure 2 is similar to that of the circuit in Figure 1. In this case, the fuse would only be opened by a larger current than a predetermined value, as shown in Figure 2B.

The solution shown in Figure 1 is the one generally adopted for BCD processes, because it provides more reliable performance over time and allows the outcome of the trimming operation to be monitored by having the terminals C and D short-circuited from outside before the trimming is carried out.

Although quite popular, the solution shown in Figure 1 has certain drawbacks.

Firstly, as many pins are required externally of the circuit as are the access terminals to the various ZAP Zener diodes. In fact, these terminals must be accessed during the EWS or final testing for trimming.

Secondly, the whole circuitry around the trimming circuit needs protection, since the voltages used for trimming may be as high as 25V and could damage the junctions and/or diffusions located electrically in the neighborhood of the ZAP Zener diode.

With the terminals C and D being accessible from outside, they become a potential source of noise in the event of no trimming being needed.

The underlying technical problem of this invention is to provide an electronic circuit for carrying out trimming operations on integrated circuits, which has such structural and functional features as to overcome the limitations and drawbacks besetting the prior art embodiments previously discussed.

Another object of this invention is to provide a trimming circuit which exhibits improved immunity to noise.

A further object of this invention is to provide a trimming circuit which has a smaller number of access pins.

Further trimming circuits are disclosed in EP 599072 and GB 2083962

### Summary of the Invention

The invention achieves these as well as other objects and advantages as made apparent by the following description.

The principle behind this invention is one of utilizing the information relating to the state of a ZAP Zener diode as digital data to be converted to a voltage analog value for modifying an electric parameter of a circuit portion associated with the trimming circuit.

Based on this principle, the technical problem is solved by a trimming circuit as previously indicated and defined in Claim 1.

The features and advantages of a circuit according to the invention will be apparent from the following description of an embodiment thereof, to be read by way of non-limiting example in conjunction with the accompanying drawings.

### Brief Description of the Drawings

Figure 1 shows diagramatically a trimming circuit of conventional construction.
Figures 1A and 1B show diagramatically the circuit of Figure 1 in two different conditions of its operation, respectively.
Figure 2 shows diagramatically another trimming circuit of conventional construction.
Figure 3 is a schematic diagram of a circuit construction according to this invention.
Figure 4 is a diagram showing the circuit of this invention in greater detail.
Figure 5 is a diagram of a first modification of the circuit construction not forming part of the claimed invention.
Figure 6 is a diagram of a second modification of the circuit construction not forming part of the claimed invention.

### Detailed Description

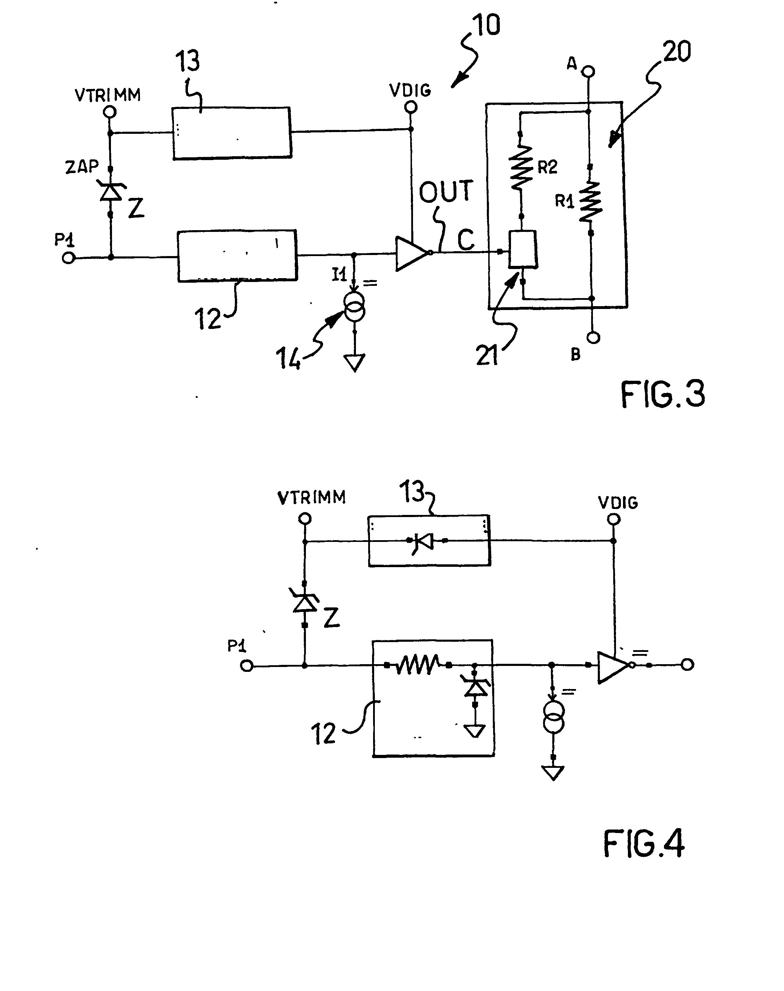

Referring to the drawing figures, specifically to the example in Figure 3, generally and schematically shown at 10 is an electronic trimming circuit embodying this invention.

The circuit 10 may be incorporated to any integrated circuit having circuit portions that require trimming. For example, the circuit 10 could be used in combination with a conventional generator of a bandgap voltage; in this case, the circuit 10 of this invention would be used for trimming the bandgap generator.

The circuit 10 has an input terminal P1 and an output terminal OUT.

A Zener diode Z of the ZAP type is connected between the input terminal P1 and a first voltage reference, e.g. a voltage V_{TRIMM}.

A protection circuit 12 is connected between the input terminal P1 and the output terminal OUT. Further connected between this protection circuit 12 and the output OUT is an inverter INV which is only provided to invert the output voltage value from the circuit 12.

This inverter INV is supplied a second voltage reference, designated V_{DIG}.

A decoupling circuit 13 is provided between the first V_{TRIMM} and second V_{DIG} voltage references.

The circuit 10 construction is completed by an element 14 arranged to keep stable the voltage value at the output terminal OUT. This element is specifically a generator 14 of a current I1 and is connected between the output of the protection circuit 12 and a third voltage reference, such as a signal ground GND. This generator 14 may be formed of a pull-down transistor, for example.

The output OUT of the circuit 10 is connected to whichever circuit or circuit portion 20 can utilize the logic value of the output OUT to modify its parameter or electric state.

As an example, the circuit 10 could be connected to a dipole comprising a first resistor R1 connected between a terminal A and a terminal B. In parallel with the resistor R1 is a series of a second resistor R2 and a controlled switch 21 arranged to receive the signal from the output OUT of the circuit 10.

Alternatively, the signal issuing from the output OUT could be used to change the mirroring ratio of a current mirror circuit, or used in any other possible ways for digital data.

The operation of the inventive circuit 10 is quite simple. With the diode Z forming an open circuit, the logic level C of the output OUT is ensured by the generator 14.

Conversely, when the diode Z forms a short circuit, the decoupling circuit 13 admits the voltage V_{DIG} to the inverter input, while the protection circuit 12 and generator 14 leave the logic level of the voltage V_{DIG} unchanged.

By applying appropriate voltage values to the input terminal P1 and the terminal V_{TRIMM}, it becomes possible to drive the trimming operation.

When no trimming is sought, the terminal P1 is only to be left free; otherwise, the voltage value at the terminal P1 should be brought to the ground GND value and the voltage at V_{TRIMM} brought to 25V, while controlling the current at 250mA.

In summary, the circuit 10 utilizes the information relating to the state of the diode Z as digital data to be converted, where required, to a voltage analog value for driving the switch 21 of the dipole A, B and change the dipole resistance.

Figure 4 is a diagram showing the circuit 10 of this invention in greater detail.

The protection circuit 12 is formed of a simple filter comprising a resistor Rp and a Zener diode Z1.

The decoupling circuit 13 is formed of a simple diode D forward biased to the second voltage reference.

When a trimming operation is to be carried out, the voltage value at the input terminal P1 should be brought to the ground GND value, and the voltage at the first reference V_{TRIMM} brought to a value of 25V, while controlling the current to 250mA.

At the end of the trimming operation, the logic value of the output OUT will be a low.

When no trimming is sought, no voltage has to be applied to the input P1. In this case, the value of the output OUT will be held high by the pull-down type of generator 14.

Where the first and second voltage references have matching pins outside the circuit, the decoupling circuit 13 can be omitted because the two pins on the mounting board can now be connected together directly.

The circuit of this invention is versatile and can be modified as required within its operating principle.

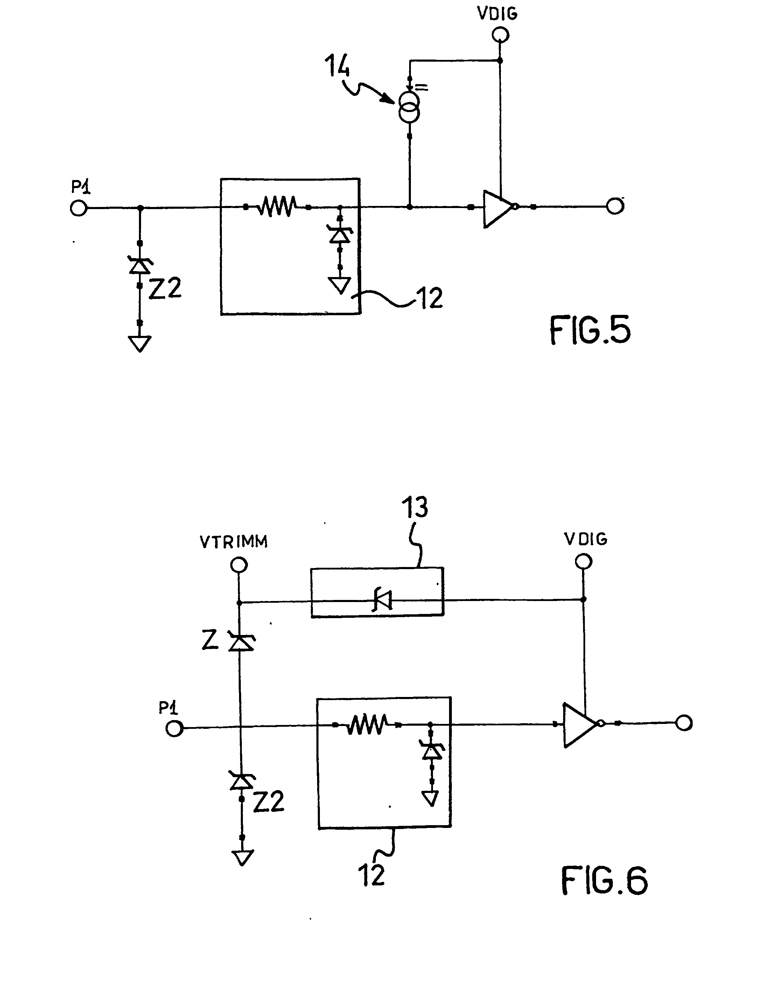

For example, referring to Figure 5, not forming part of the claimed invention the diode Z may be connected in a modified embodiment between the input terminal P1 and the third voltage reference GND.

In this modification, neither the first voltage reference V_{TRIMM} nor the decoupling circuit 13 between the first and second voltage references are required.

Here again, the protection circuit 12 is a simple filter comprising a resistor Rp and Zener diode Z1.

The connection of the generator 14 has been altered such that the output of the protection circuit 12 is connected to the second voltage reference. In this case, the generator 14 may be formed with a pull-up transistor.

For a trimming operation, it is sufficient to bring the voltage at the terminal P1 to a value near 25V while circulating a current of 250mA.

At the end of the trimming operation, the logic level at the output terminal OUT will be a high.

Where no trimming is sought, no voltage value has to be brought to the input terminal P1. The logic level of the signal at the output OUT is held low by the pull-up generator 14 provided.

It should be noted that the second voltage reference V_{DIG} could be an internal supply line instead of a pin outside the circuit.

A further modified embodiment of the inventive circuit is shown in Figure 6; not forming part of the claimed invention.

This embodiment comprises a first diode Z connected between the input P1 and the first voltage reference, and a second diode Z2 connected between the input P1 and the third voltage reference. The diodes Z and Z2 are of ZAP type.

The connection for the generator 14 has been omitted.

To provide a logic low on the output OUT, the voltage at the terminal P1 should be brought to a value near the ground GND, while the voltage value at the first voltage reference is brought to 25V and the current controlled at 250mA.

To provide a logic high on the output OUT, the voltage at the terminal P1 should be brought to a value close to 25V, while the voltage value at the first voltage reference is brought to 25V and the current controlled at 250mA.

Where pins are provided outside the circuit which correspond to the first and second voltage references, the decoupling circuit 13 can be omitted since the two pins on the mounting board can be connected together directly.

The circuit of this invention does solve the technical problem, and affords a number of advantages of which the following are noteworthy:
increased immunity to noise;
protection is only required for the trimming circuitry, because the remaining circuitry is coupled to the inventive circuit through a logic signal only;
a smaller number of external pins is required: for example, as many pins as are the trimming circuits used during EWS and final testing; in any event, the number of external pins is always smaller than in prior art constructions.

## Claims

1. An electronic circuit (10) for carrying out a trimming operation on circuit portions (20) of integrated circuits, including at least an input terminal (P1) and an output terminal (OUT) connected to at least one of said circuit portions, and comprising:
at least one ZAP Zener diode (Z) connected between the input terminal (P1) and a just voltage reference (V_{TRIMM}, GND);
a protection circuit (12) connected between the input terminal (P1) and the output terminal (OUT);
a means (14) for keeping the voltage stable on the output terminal (OUT) until said ZAP diode (Z) changes in state; and
an inverter (INV) placed between said protection circuit (12) and the output terminal (OUT), supplied by a second voltage reference (V_{DIG}), the protection circuit (12) avoiding overstressing of said inverter (INV)
**characterized in that** it further comprises a decoupling circuit (13) placed between the first (V_{TRIMM}) and second (V_{DIG}) voltage references.

2. A trimming circuit according to Claim 1, **characterized in that** a generator (14) of a current (I1) is connected between the output of the protection circuit (12) and a voltage reference (GND).

3. A trimming circuit according to Claim 2, **characterized in that** said generator (14) is a pull-down transistor.

4. A trimming circuit according to Claim 1, **characterized in that** the protection circuit (12) is a filter comprising a resistor and a Zener diode (21) connected to said inverter (INV) in such a way to avoid overstressing of the inverter itself.

5. A trimming circuit according to Claim 1, **characterized in that** said decoupling circuit is a diode (D) forward biased to the second voltage reference (V_{DIC}).

6. A trimming circuit according to Claim 1, **characterized in that** said second voltage reference (V_{DIG}) is a supply line internal of the circuit.

7. A trimming circuit according to Claim 1, **characterized in that** it comprises a second ZAP Zener diode (Z2) connected between the input terminal (P1) and a further voltage reference (GND).

## Patentansprüche

1. Elektronische Schaltung (10) zum Ausführen eines Trimmvorgangs an Schaltungsabschnitten (20) von integrierten Schaltungen, mit wenigstens einem Eingangsanschluss (P1) und einem Ausgangsanschluss (OUT), die an wenigstens einem der Schaltungsabschnitte angeschlossen sind, und umfassend:
wenigstens eine ZAP-Zenerdiode (Z), die zwischen dem Eingangsanschluss (P1) und einer ersten Spannungsreferenz (V_{TRIMM}, GND) angeschlossen ist;
eine Schutzschaltung (12), die zwischen dem Eingangsanschluss (P1) und dem Ausgangsanschluss (OUT) angeschlossen ist;
eine Einrichtung (14), um die Spannung am Ausgangsanschluss (OUT) stabil zu halten, bis die ZAP-Diode (Z) ihren Zustand ändert; und
einen Inverter (INV), der zwischen die Schutzschaltung (12) und den Ausgangsanschluss (OUT) gesetzt ist und von einer zweiten Spannungsreferenz (V_{DIG}) versorgt wird, wobei durch die Schutzschaltung (12) eine Überbelastung des Inverters (INV) vermieden ist,
**dadurch gekennzeichnet, dass** sie darüber hinaus eine Entkopplungsschaltung (13) umfasst, die zwischen die erste (V_{TRIMM}) und zweite (V_{DIG}) Spannungsreferenz gesetzt ist.

2. Trimmschaltung nach Anspruch 1, **dadurch gekennzeichnet, dass** ein Generator (14) eines Stroms (11) zwischen dem Ausgang der Schutzschaltung (12) und einer Spannungsreferenz (GND) angeschlossen ist.

3. Trimmschaltung nach Anspruch 2, **dadurch gekennzeichnet, dass** der Generator (14) ein Pull-down-Transistor ist.

4. Trimmschaltung nach Anspruch 1, **dadurch gekennzeichnet, dass** die Schutzschaltung (12) ein Filter ist, der einen Widerstand und eine Zenerdiode (Z1) umfasst, die an den Inverter (INV) so angeschlossen ist, dass eine Überbelastung des Inverters selbst vermieden ist.

5. Trimmschaltung nach Anspruch 1, **dadurch gekennzeichnet, dass** die Entkopplungsschaltung eine Diode (D) ist, die in Vorwärtsrichtung auf die zweite Spannungsreferenz (V_{DIG}) vorgespannt ist.

6. Trimmschaltung nach Anspruch 1, **dadurch gekennzeichnet, dass** die zweite Spannungsreferenz (V_{DIG}) eine im Inneren der Schaltung befindliche Versorgungsleitung ist.

7. Trimmschaltung nach Anspruch 1, **dadurch gekennzeichnet, dass** sie eine zweite ZAP-Zenerdiode (Z2) umfasst, die zwischen dem Eingangsanschluss (P1) und einer weiteren Spannungsreferenz (GND) angeschlossen ist.

## Revendications

1. Circuit électronique (10) pour la mise en oeuvre d'une opération de modification d'ajustement sur des parties (20) de circuits intégrés, incluant au moins une borne d'entrée (P1) et une borne de sortie (OUT) connectées à au moins l'une desdites parties de circuits, et comprenant :
au moins une diode Zener ZAP (Z) connectée entre la borne d'entrée (P1) et une première référence de tension (V_{TRIMM}, GND);
un circuit de protection (12) connecté entre la borne d'entrée (P1) et la borne de sortie (OUT);
des moyens (14) pour maintenir la tension stable sur la borne de sortie (OUT) jusqu'à ce que ladite diode ZAP (Z) change d'état; et
un inverseur (INV) disposé entre ledit circuit de protection (12) et la borne de sortie OUT, alimenté par une seconde référence de tension (V_{DIG}), le circuit de protection (12) évitant une contrainte excessive dudit inverseur (INV),
**caractérisé en ce qu'**il comporte en outre un circuit de découplage (13) disposé entre la première référence de tension (V_{TRIMM}) et la seconde référence de tension (V_{DIG}).

2. Circuit de modification d'ajustement selon la revendication 1, **caractérisé en ce qu'**un générateur (14) d'un courant (I1) est connecté entre la sortie du circuit de protection (12) et une référence de tension (GND).

3. Circuit de modification d'ajustement selon la revendication 2, **caractérisé en ce que** ledit générateur (14) est un transistor abaisseur.

4. Circuit de modification d'ajustement selon la revendication 1, **caractérisé en ce que** le circuit de protection (12) est un filtre comprenant une résistance et une diode Zener (Z1), connectées audit inverseur (INV) de manière à éviter une contrainte excessive de l'inverseur lui-même.

5. Circuit de modification d'ajustement selon la revendication 1, **caractérisé en ce que** ledit circuit de découplage est une diode (D) polarisée dans le sens direct pour la seconde référence de tension (V_{DIG}).

6. Circuit de modification d'ajustement selon la revendication 1, **caractérisé en ce que** ladite seconde référence de tension (V_{DIG}) est une ligne d'alimentation à l'intérieur du circuit.

7. Circuit de modification d'ajustement selon la revendication 1, **caractérisé en ce qu'**il comprend une seconde diode Zener ZAP (Z2) connectée entre la borne d'entrée (P1) et une autre référence de tension (GND).
